# EUROPEAN PATENT APPLICATION

(11) **EP 3 498 472 A1**
(43) Date of publication of application: **19.06.2019**
(21) Application number: 18174128.1
(22) Date of filing: 24.05.2018
(51) Int. Cl.: B32B 37/10, H01L 31/048, H02S 50/10

(54) **METHOD FOR SIMULATING FLEXIBLE CELL CHIP LAMINATION PROCESS AND LAMINATION ASSEMBLY**

(30) Priority: 13.12.2017 CN 201711328901
(71) Applicant: Miasolé Equipment Integration (Fujian) Co., Ltd., 362005 Quanzhou Fujian (CN)
(72) Inventor: PAN, Deng, Quanzhou, Fujian 362005 (CN); HU, Chao, Quanzhou, Fujian 362005 (CN); SHU, Yi, Quanzhou, Fujian 362005 (CN); CHEN, Fan, Quanzhou, Fujian 362005 (CN); ZHU, Pengjian, Quanzhou, Fujian 362005 (CN); SUN, Hongxia, Quanzhou, Fujian 362005 (CN); YAO, Wenbiao, Quanzhou, Fujian 362005 (CN); ZHOU, Bo, Quanzhou, Fujian 362005 (CN); XU, Guojun, Quanzhou, Fujian 362005 (CN)
(74) Representative: Allain, Laurent

(57) **Abstract**

The present disclosure provides a method for simulating flexible cell chip lamination process and a lamination assembly (20). The method comprises the steps of: laying a first high-temperature resistant cloth (22) on a bottom plate (21); laying a flexible cell chip (30) to be evaluated on the first high-temperature resistant cloth (22); laying a second high-temperature resistant cloth (23) on the flexible cell chip (30) to be evaluated; laying a top plate (24) on the second high-temperature resistant cloth (23) to form a lamination assembly (20); and placing the lamination assembly (20) into a lower chamber (13) of a laminator (10) having an upper chamber (131) and the lower chamber (13) and laminating the lamination assembly (20).

## Description

### CROSS-REFERENCE TO RELATED APPLICATION

This application claims the priority of Chinese Patent Application No. 201711328901.3 submitted to the Chinese Intellectual Property Office on December 13, 2017, the disclosure of which is incorporated herein in its entirety by reference.

### TECHNICAL FIELD

The present disclosure relates to the technical field of solar cells, and particularly relates to a method for simulating flexible cell chip lamination process and a lamination assembly.

### BACKGROUND OF THE INVENTION

At present, the solar cell industry has developed into a relatively mature stage, and solar cell module laminate packaging has also become relatively mature technology, in which the quality of flexible cell chips plays a decisive role in the performance of solar cells.

It is a common method at present to verify whether the production process of a flexible cell chip is qualified by evaluating a conversion rate of the solar cell. The method requires laminating the flexible cell chip with a back plate, a front plate, and the like to form a complete solar cell before evaluating whether the flexible cell chip production process is qualified according to a conversion rate of the complete solar cell.

At present, during evaluation on advantages and disadvantages of a flexible cell chip, the evaluation can only be performed after processing of the entire solar cell is finished. However, the cycle required to complete the entire solar cell is very long, which makes it difficult to obtain the evaluation result of the production process in a short term. Thus, it is difficult for an R&D worker to make adjustments to the production process in a timely manner, resulting in lengthy R&D cycles and severely reduced production efficiency.

### SUMMARY

The present disclosure has been accomplished in order to at least partially solve the problems in the existing art. The disclosure provides a method for simulating flexible cell chip lamination process and a lamination assembly that can rapidly simulate a state of a flexible cell chip after the holistic processing is finished so as to obtain the evaluation result of the production process in time.

According to one aspect of the disclosure, there is provided a method for simulating flexible cell chip lamination process, comprising the steps of:
laying a first high-temperature resistant cloth on a bottom plate;
laying a flexible cell chip to be evaluated on the first high-temperature resistant cloth;
laying a second high-temperature resistant cloth on the flexible cell chip to be evaluated;
laying a top plate on the second high-temperature resistant cloth to form a lamination assembly; and
placing the lamination assembly into a lower chamber of a laminator having an upper chamber and the lower chamber and laminating the lamination assembly.

The first high-temperature resistant cloth may be a Teflon high-temperature cloth; and
the second high-temperature resistant cloth may be a Teflon high-temperature cloth.

The step of laying the flexible cell chip to be evaluated on the first high-temperature resistant cloth may include: laying a plurality of flexible cell chips to be evaluated spaced apart from each other by a preset distance on the first high-temperature resistant cloth.

The number of the flexible cell chips to be evaluated laid on the first high-temperature resistant cloth may be 1 to 42.

The number of the flexible cell chips to be evaluated laid on the first high-temperature resistant cloth may be 6.

The step of laminating the lamination assembly may include:
vacuuming the upper chamber and the lower chamber of the laminator, while preheating the lamination assembly;
pressurizing the upper chamber of the laminator so that a pressure within the upper chamber is increased to a preset pressure value, and keeping the upper chamber at the preset pressure value for a preset time period; and
taking the lamination assembly out of the lower chamber of the laminator and cooling the lamination assembly.

The step of pressurizing the upper chamber of the laminator so that the pressure within the upper chamber is increased to the preset pressure value, and keeping the upper chamber at the preset pressure value for the preset time period may include: pressurizing the upper chamber of the laminator so that the pressure within the upper chamber is increased to 101 KPa within 1 minute, and keeping the upper chamber at 101 KPa for 10 minutes.

The bottom plate may be a high-temperature resistant plastic plate.

The top plate may be a high-temperature resistant foam plate.

The first high-temperature resistant cloth has a same area with the second high-temperature resistant cloth; an area of a side end face of the top plate facing the second high-temperature resistant cloth is greater than an area of the second high-temperature resistant cloth; and an area of a side end face of the bottom plate facing the first high-temperature resistant cloth is greater than the area of the side end face of the top plate facing the second high-temperature resistant cloth.

The laminator may include an inflatable member, which separates the upper chamber and the lower chamber and is configured to pressurize the upper chamber of the laminator by being inflated.

According to another aspect of the disclosure, there is provided a lamination assembly, comprising:
a bottom plate;
a first high-temperature resistant cloth laid on the bottom plate;
a flexible cell chip to be evaluated laid on the first high-temperature resistant cloth;
a second high-temperature resistant cloth laid on the flexible cell chip to be evaluated; and
a top plate laid on the second high-temperature resistant cloth.

The bottom plate may be a high-temperature resistant plastic plate.

The bottom plate may be made of epoxy resin.

The top plate may be a high-temperature resistant foam plate.

The first and second high-temperature resistant cloths may both be Teflon high-temperature cloths.

The number of the flexible cell chips may be 1 to 42.

The number of the flexible cell chips may be 6.

The first high-temperature resistant cloth has a same area with the second high-temperature resistant cloth; an area of a side end face of the top plate facing the second high-temperature resistant cloth is greater than an area of the second high-temperature resistant cloth; and an area of a side end face of the bottom plate facing the first high-temperature resistant cloth is greater than the area of the side end face of the top plate facing the second high-temperature resistant cloth.

Each of the flexible cell chips may be processed using a different process scheme.

### BRIEF DESCRIPTION OF THE FIGURES

Fig. 1 is a structural schematic view showing a laminator used in a method for simulating flexible cell chip lamination process according to an exemplary embodiment of the disclosure;
Fig. 2 is a cross-sectional view showing the laminator used in the method for simulating flexible cell chip lamination process according to the exemplary embodiment of the disclosure;
Fig. 3 is a structural schematic view showing a lamination assembly according to an exemplary embodiment of the disclosure; and
Fig. 4 is a schematic view showing a first high-temperature resistant cloth of the lamination assembly laid with a plurality of flexible cell chips according to an exemplary embodiment of the disclosure.

### DETAILED DESCRIPTION

The exemplary embodiments of the disclosure will now be described in detail with reference to the drawings in which the same or similar reference signs refer to the same or similar elements or elements with the same or similar functions. It should be appreciated that the embodiments described below with reference to the drawings are merely illustrative, and are used only for the purpose of explaining the disclosure and should not be interpreted as limitations to the disclosure.

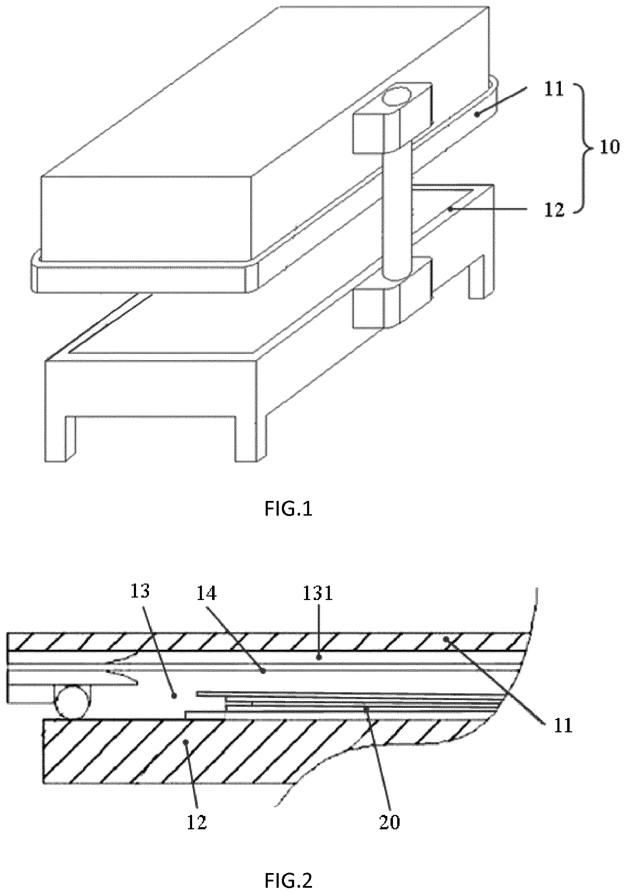

According to one aspect of the disclosure, there is provided a method for simulating flexible cell chip lamination process. As shown in Fig. 1, the method for simulating flexible cell chip lamination process according to an exemplary embodiment of the disclosure uses a laminator 10 including a case cover 11 and a workbench 12. The case cover 11 is movable downward to cooperate with the workbench 12 to form a sealed lamination chamber. As shown in Fig. 2, the case cover 11 is provided with a balloon 14 at a side closer to the workbench 12. When the case cover 11 cooperates with the workbench 12, an upper chamber 131 is formed between the balloon 14 and an inner wall of the case cover 11, while a lower chamber 13 is formed between the balloon 14 and the workbench 12, i.e., the sealed lamination chamber is divided into the upper chamber 131 and the lower chamber 13 by the balloon 14.

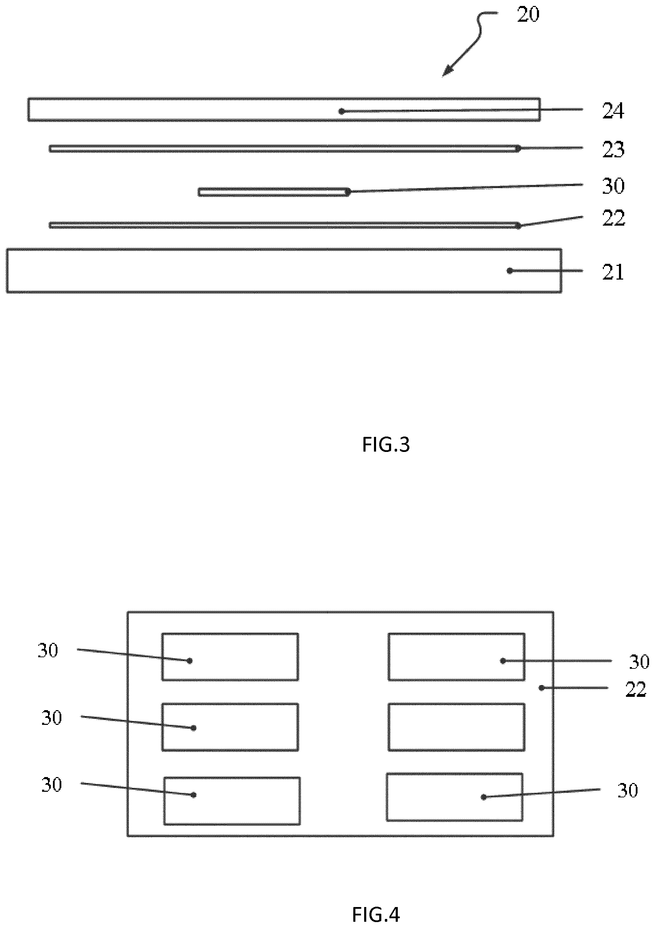

An flexible cell chip 30 (shown in Figs. 3 and 4) of the disclosure includes, from top to bottom successively, a top electrode, a transparent conductive layer, a buffer layer, an absorptive layer, a barrier layer and a stainless steel substrate. The top electrode is disposed at a surface of the flexible cell chip 30 and generally used for collecting current.

During actual production and processing, after being processed, the flexible battery chip 30 is laminated with a front plate and a back plate to form a complete solar cell including, from top to bottom successively, the front plate, an EVA adhesive film, the flexible cell chip 30, an EVA adhesive film and the back plate. It should be noted that during the lamination of the flexible cell chip 30 with the front and back plates, a material of the top electrode on the surface of the flexible cell chip 30 may be melted, and after the lamination is completed and the solar cell is removed from the laminator 10, the top electrode on the surface of the flexible cell chip 30 will be cured.

The method for simulating flexible cell chip lamination process according to the exemplary embodiment of the disclosure will now be described in detail with reference to Figs. 1 to 4. The method for simulating flexible cell chip lamination process according to the exemplary embodiment of the disclosure includes:
Step S1, laying a first high-temperature resistant cloth 22 on a bottom plate 21. In an exemplary embodiment of the disclosure, the bottom plate 21 is a high-temperature resistant plastic plate which may be made of epoxy resin. The first high-temperature resistant cloth 22 may be a Teflon high-temperature cloth with good anti-corrosion and heat-resistance performance, a smooth surface, and good tack-free performance.
Step S2: laying a flexible cell chip 30 to be evaluated on the first high-temperature resistant cloth 22. As shown in Fig. 4, a plurality of flexible cell chips 30 to be evaluated may be laid on the first high-temperature resistant cloth 22 as needed. When laying the plurality of flexible cell chips 30, in order to avoid interference with each other, the plurality of flexible cell chips 30 are spaced apart from each other at a preset distance, which can be set by those skilled in the art as needed as long as each two of the flexible cell chips 30 do not interfere with each other.
   In an exemplary embodiment of the disclosure, each of the flexible cell chips 30 is processed using a different process scheme so that an R&D worker may evaluate various production schemes at one time conveniently, thus speeding up the production beats. In an exemplary embodiment of the disclosure, the number of the flexible cell chips 30 may be 1 to 42. In the exemplary embodiment shown in Fig. 4, the first high-temperature resistant cloth 22 is laid with six flexible cell chips 30. It has been verified through experiments that laying six flexible cell chips 30 can obtain the best lamination effect and a relatively higher processing efficiency.
Step S3: laying a second high-temperature resistant cloth 23 on the flexible cell chip 30 to be evaluated. The first high-temperature resistant cloth 22 and the second high-temperature resistant cloth 23 sandwich the flexible cell chip 30 to be evaluated therebetween so as to ensure that the flexible cell chip 30 is in a state similar to being bonded by an adhesive film during lamination. In an exemplary embodiment of the disclosure, the second high-temperature resistant cloth 23 may be a Teflon high-temperature cloth with good anti-corrosion and heat-resistance performance, a smooth surface, and good tack-free performance.
Step S4: laying a top plate 24 on the second high-temperature resistant cloth 23 to form a lamination assembly 20. In an exemplary embodiment of the disclosure, the top plate 24 may be a high-temperature resistant foam plate.
Step S5: placing the lamination assembly 20 into a lower chamber 13 of a laminator 10 and laminating the lamination assembly 20. Specifically, the Step S5 includes:
   Step S501: vacuuming an upper chamber 131 and the lower chamber 13 of the laminator 10, while preheating the lamination assembly 20. Specifically, the upper chamber 131 and the lower chamber 13 of the laminator 10 are vacuumed for 4 minutes, while preheating is performed at the same time, i.e., vacuuming and preheating both last for 4 minutes.
   Step S502: pressurizing the upper chamber 131 of the laminator 10 so that a pressure within the upper chamber 131 is increased to a preset pressure value, and keeping the upper chamber 131 at the preset pressure value for a preset time period. Specifically, the upper chamber 131 of the laminator 10 is pressurized so that the pressure within the upper chamber 131 is increased to 101 KPa within 1 minute, and the upper chamber 131 is kept at 101 KPa for 10 minutes. That is, the preset pressure value is 101 KPa, and the preset time period is 10 minutes. Further, pressurizing the upper chamber 131 is realized by the balloon 14, i.e., during the pressurizing, the lower chamber 13 is kept in a vacuum state while the balloon is inflated. The stage of keeping the preset pressure for 10 minutes is a lamination stage, which is also called a pressure-keeping stage. At this time, the lower chamber 13 is still kept in a vacuum state while the balloon 14 is still kept inflated.
   Step S503: taking the lamination assembly 20 out of the lower chamber 13 of the laminator 10 and cooling the lamination assembly 20. The case cover 11 is desired to be opened when the lamination assembly 20 is taken out. At this time, air goes into the lower chamber 13 and the balloon 14 is deflated.

It should be noted that the order of the above steps is not limited herein as long as the lamination assembly can be formed. For example, before the Step S3, the top plate 24 may be laid on the second high-temperature resistant cloth 23, and then the integral member formed by the second high-temperature resistant cloth 23 and the top plate 24 is laid on the flexible cell chip to be evaluated to form the lamination assembly.

In the flexible cell chip 30 laminated by the method for simulating flexible cell chip lamination process according to the exemplary embodiment of the disclosure, a material of the top electrode on the surface of the flexible cell chip 30 is melted after being heated and pressurized in the lower chamber 13, and the material is cured again when the flexible cell chip 30 is taken out from the laminator 10. This process is substantially the same as the process endured by the material of the top electrode during lamination of the flexible cell chip 30 with the front plate, the back plate, the EVA adhesive films, and the like. Therefore, an R&D worker may evaluate a flexible cell chip 30 laminated in this method and determine whether the used processing technique is proper.

In the disclosure, since the lamination state of the flexible cell chip is simulated by laying the first high-temperature resistant cloth 22, the flexible cell chip 30 to be evaluated, the second high-temperature resistant cloth 23 and the top plate 24 on the bottom plate 21, it does not require finishing processing of the entire solar cell and involves a very short cycle, thereby facilitating obtaining an evaluation result of the production process in a short term and thus adjusting the production process timely to shorten the whole R&D cycle.

In an exemplary embodiment of the disclosure, the first high-temperature resistant cloth 22 has a same area with the second high-temperature resistant cloth 23; an area of a side end face of the top plate 24 facing the second high-temperature resistant cloth 23 is greater than an area of the second high-temperature resistant cloth 23; and an area of a side end face of the bottom plate 21 facing the first high-temperature resistant cloth 22 is greater than the area of the side end face of the top plate 24 facing the second high-temperature resistant cloth 23. That is, the bottom plate 21 has the largest size so that it can support the first high-temperature resistant cloth 22, the second high-temperature resistant cloth 23, the top plate 24 and the flexible cell chip 30 to be evaluated, and prevent the first high-temperature resistant cloth 22, the second high-temperature resistant cloth 23, the top plate 24 and the flexible cell chip 30 to be evaluated from falling down and being damaged due to a too small size of the bottom plate 21.

The first high-temperature resistant cloth 22 and the second high-temperature resistant cloth 23 sandwich the flexible cell chip 30 to be evaluated therebetween. Since the two high-temperature resistant cloths have the same size, it can facilitate arrangement of the flexible cell chip 30 to be evaluated and prevent an upper or lower surface of the flexible cell chip 30 to be evaluated from being uncovered due to different sizes of the two resistant cloths, thereby affecting the lamination effect and finally adjustments of the process.

The top plate 24 is laid on the second high-temperature resistant cloth 23. In order to cover the second high-temperature resistant cloth 23 completely, the top plate 24 should have a size larger than the second high-temperature resistant cloth 23. In this way, it can be ensured that the whole lamination assembly is much closer to an actual solar cell.

With the method for simulating flexible cell chip lamination process according to the disclosure, a state of the flexible cell chip after a holistic process can be simulated quickly. As a result, an evaluation result of the production process can be obtained timely, and thus an R&D worker is able to make timely adjustments to the production process, shorten the R&D cycle, and improve the production efficiency.

According to another aspect of the disclosure, there is provided a lamination assembly. As shown in Fig. 3, the lamination assembly 20 includes a bottom plate 21, a first high-temperature resistant cloth 22, a flexible cell chip 30 to be evaluated, a second high-temperature resistant cloth 23 and a top plate 24.

The bottom plate 21 is configured to support the first high-temperature resistant cloth 22, the second high-temperature resistant cloth 23, the top plate 24 and the flexible cell chip 30 to be evaluated. In an exemplary embodiment of the disclosure, the bottom plate 21 is a high-temperature resistant plastic plate which may be made of epoxy resin. The first high-temperature resistant cloth 22 is laid on the bottom plate 21; the flexible cell chip 30 to be evaluated is laid on the first high-temperature resistant cloth 22; the second high-temperature resistant cloth 23 is laid on the flexible cell chip 30 to be evaluated; and the top plate 24 is laid on the second high-temperature resistant cloth 23. The top plate 24 is preferably a high-temperature resistant foam plate. In an exemplary embodiment of the disclosure, the first high-temperature resistant cloth 22 and the second high-temperature resistant cloth 23 may both be Teflon high-temperature cloths with good anti-corrosion and heat-resistance performance, a smooth surface, and good tack-free performance.

The bottom plate 21, the first high-temperature resistant cloth 22, the second high-temperature resistant cloth 23 and the top plate 24 have the same function with a front plate, a back plate and adhesive films in a solar cell so that an R&D worker may make a quick evaluation on the process of the flexible cell chip 30.

As shown in Fig. 4, a plurality of flexible cell chips 30 to be evaluated may be laid on the first high-temperature resistant cloth 22 as needed. When laying the plurality of flexible cell chips 30, in order to avoid interference with each other, the plurality of flexible cell chips 30 are spaced apart from each other at a preset distance, which can be set by those skilled in the art as needed as long as each two of the flexible cell chips 30 do not interfere with each other. In an exemplary embodiment of the disclosure, the number of the flexible cell chips 30 may be 1 to 42. In the exemplary embodiment shown in Fig. 4, the first high-temperature resistant cloth 22 is laid with six flexible cell chips 30. It has been verified through experiments that laying six flexible cell chips 30 can obtain the best lamination effect and a relatively higher processing efficiency.

In an exemplary embodiment of the disclosure, the first high-temperature resistant cloth 22 has a same area with the second high-temperature resistant cloth 23; an area of a side end face of the top plate 24 facing the second high-temperature resistant cloth 23 is greater than an area of the second high-temperature resistant cloth 23; and an area of a side end face of the bottom plate 21 facing the first high-temperature resistant cloth 22 is greater than the area of the side end face of the top plate 24 facing the second high-temperature resistant cloth 23. That is, the bottom plate 21 has the largest size so that it can support the first high-temperature resistant cloth 22, the second high-temperature resistant cloth 23, the top plate 24 and the flexible cell chip 30 to be evaluated, and prevent the first high-temperature resistant cloth 22, the second high-temperature resistant cloth 23, the top plate 24 and the flexible cell chip 30 to be evaluated from falling down and being damaged due to a too small size of the bottom plate 21.

The first high-temperature resistant cloth 22 and the second high-temperature resistant cloth 23 sandwich the flexible cell chip 30 to be evaluated therebetween. Since the two high-temperature resistant cloths have the same size, it can facilitate arrangement of the flexible cell chip 30 to be evaluated and prevent an upper or lower surface of the flexible cell chip 30 to be evaluated from being uncovered due to different sizes of the two resistant cloths, thereby affecting the lamination effect and finally adjustments of the process.

The top plate 24 is laid on the second high-temperature resistant cloth 23. In order to cover the second high-temperature resistant cloth 23 completely, the top plate 24 should have a size larger than the second high-temperature resistant cloth 23. In this way, it can be ensured that the whole lamination assembly is much closer to an actual solar cell.

With the lamination assembly according to the disclosure, a state of the flexible cell chip after a holistic process can be simulated quickly. As a result, an evaluation result of the production process can be obtained timely, and thus an R&D worker is able to make timely adjustments to the production process, shorten the R&D cycle, and improve the production efficiency.

It should be understood that the above embodiments are merely exemplary embodiments for the purpose of illustrating the principle of the disclosure, and the disclosure is not limited thereto. Various modifications and improvements can be made by a person having ordinary skill in the art without departing from the spirit and essence of the disclosure. Accordingly, all of the modifications and improvements also fall into the protection scope of the disclosure.

## Claims

1. A method for simulating flexible cell chip lamination process, comprising the steps of:
laying a first high-temperature resistant cloth (22) on a bottom plate (21);
laying a flexible cell chip (30) to be evaluated on the first high-temperature resistant cloth (22);
laying a second high-temperature resistant cloth (23) on the flexible cell chip (30) to be evaluated;
laying a top plate (24) on the second high-temperature resistant cloth (23) to form a lamination assembly (20); and
placing the lamination assembly (20) into a lower chamber (13) of a laminator (10) having an upper chamber (131) and the lower chamber (13) and laminating the lamination assembly (20).

2. The method of claim 1,
wherein the first high-temperature resistant cloth (22) is a Teflon high-temperature cloth; and
wherein the second high-temperature resistant cloth (23) is a Teflon high-temperature cloth.

3. The method of claim 1,
wherein the step of laying the flexible cell chip (30) to be evaluated on the first high-temperature resistant cloth (22) includes: laying a plurality of flexible cell chips (30) to be evaluated spaced apart from each other by a preset distance on the first high-temperature resistant cloth (22).

4. The method of claim 3,
wherein the number of the flexible cell chips (30) to be evaluated laid on the first high-temperature resistant cloth (22) is 1 to 42,
preferably, the number of the flexible cell chips (30) to be evaluated laid on the first high-temperature resistant cloth (22) is 6.

5. The method of claim 1,
wherein the step of laminating the lamination assembly (20) includes:
vacuuming the upper chamber (131) and the lower chamber (13) of the laminator (10), while preheating the lamination assembly (20);
pressurizing the upper chamber (131) of the laminator (10) so that a pressure within the upper chamber (131) is increased to a preset pressure value, and keeping the upper chamber (131) at the preset pressure value for a preset time period; and
taking the lamination assembly (20) out of the lower chamber (13) of the laminator (10) and cooling the lamination assembly (20).

6. The method of claim 5,
wherein the step of pressurizing the upper chamber (131) of the laminator (10) so that the pressure within the upper chamber (131) is increased to the preset pressure value, and keeping the upper chamber (131) at the preset pressure value for the preset time period includes: pressurizing the upper chamber (131) of the laminator (10) so that the pressure within the upper chamber (131) is increased to 101 KPa within 1 minute, and keeping the upper chamber (131) at 101 KPa for 10 minutes.

7. The method of claim 1,
wherein the bottom plate (21) is a high-temperature resistant plastic plate, and
wherein the top plate (24) is a high-temperature resistant foam plate.

8. The method of any one of claims 1-7,
wherein the first high-temperature resistant cloth (22) has a same area with the second high-temperature resistant cloth (23); an area of a side end face of the top plate (24) facing the second high-temperature resistant cloth (23) is greater than an area of the second high-temperature resistant cloth (23); and an area of a side end face of the bottom plate (21) facing the first high-temperature resistant cloth (22) is greater than the area of the side end face of the top plate (24) facing the second high-temperature resistant cloth (23).

9. The method of claim 1,
wherein the laminator (10) comprises an inflatable member (14), which separates the upper chamber (131) and the lower chamber (13) and is configured to pressurize the upper chamber (131) of the laminator (10) by being inflated.

10. A lamination assembly (20), comprising:
a bottom plate (21);
a first high-temperature resistant cloth (22) laid on the bottom plate (21);
a flexible cell chip (30) to be evaluated laid on the first high-temperature resistant cloth (22);
a second high-temperature resistant cloth (23) laid on the flexible cell chip (30) to be evaluated; and
a top plate (24) laid on the second high-temperature resistant cloth (23).

11. The lamination assembly (20) of claim 10,
wherein the bottom plate (21) is a high-temperature resistant plastic plate, and
wherein the top plate (24) is a high-temperature resistant foam plate,
preferably, the bottom plate (21) is made of epoxy resin.

12. The lamination assembly (20) of claim 10,
wherein the first and second high-temperature resistant cloths (22, 23) are both Teflon high-temperature cloths.

13. The lamination assembly (20) of claim 10,
wherein the number of the flexible cell chips (30) is 1 to 42,
preferably, the number of the flexible cell chips (30) is 6.

14. The lamination assembly (20) of any one of claims 10-13,
wherein the first high-temperature resistant cloth (22) has a same area with the second high-temperature resistant cloth (23); an area of a side end face of the top plate (24) facing the second high-temperature resistant cloth (23) is greater than an area of the second high-temperature resistant cloth (23); and an area of a side end face of the bottom plate (21) facing the first high-temperature resistant cloth (22) is greater than the area of the side end face of the top plate (24) facing the second high-temperature resistant cloth (23).

15. The lamination assembly (20) of claim 13,
wherein each of the flexible cell chips (30) is processed using a different process scheme.
